# EUROPEAN PATENT SPECIFICATION

(11) **EP 2 843 428 B1**
(45) Date of publication and mention of the grant of the patent: **17.03.2021**
(21) Application number: 13187304.4
(22) Date of filing: 04.10.2013
(51) Int. Cl.: G01R 31/14, H02H 9/04

(54) **Devices and methods for providing an impulse current**
Vorrichtungen und Verfahren zur Bereitstellung von Impulsstrom
Dispositifs et procédés pour fournir un courant d'impulsion

(30) Priority: 30.08.2013 GR 20130100490; 12.09.2013 US 201314024690
(43) Date of publication of application: 04.03.2015
(73) Proprietor: Raycap Intellectual Property, Ltd., Nicosia (CY)
(72) Inventor: Kostakis, Grigoris, 17673 Athens (GR); Giannelaki, Evaggelia, 66100 Drama (GR); Tsovilis, Thomas, 66100 Drama (GR); Politis, Zafiris, 14565 Athens (GR)
(74) Representative: Haseltine Lake Kempner LLP

(56) References cited:
- EP-A1- 2 336 793
- DE-A1- 4 341 924
- KR-A- 20120 044 689
- KR-B1- 100 992 429

## Description

### FIELD OF THE INVENTION

The present invention relates to device testing and, more particularly, to devices and methods for testing protection devices.

### BACKGROUND

Frequently, excessive voltage or current is applied across service lines that deliver power to residences and commercial and institutional facilities. Such excess voltage or current spikes (transient overvoltages and surge currents) may result from lightning strikes, for example. The above events may be of particular concern in telecommunications distribution centers, hospitals and other facilities where equipment damage caused by overvoltages and/or current surges and resulting down time may be very costly.

Typically, sensitive electronic equipment may be protected against transient overvoltages and surge currents using Surge Protective Devices (SPDs). Since SPDs may be relied upon to protect sensitive and potentially costly electronic equipment, manufacturers of such devices may perform stringent performance testing on SPDs using one or more testing regimens. For example, high current generators may be used to produce current waveforms in order to experimentally simulate lightning related surges.

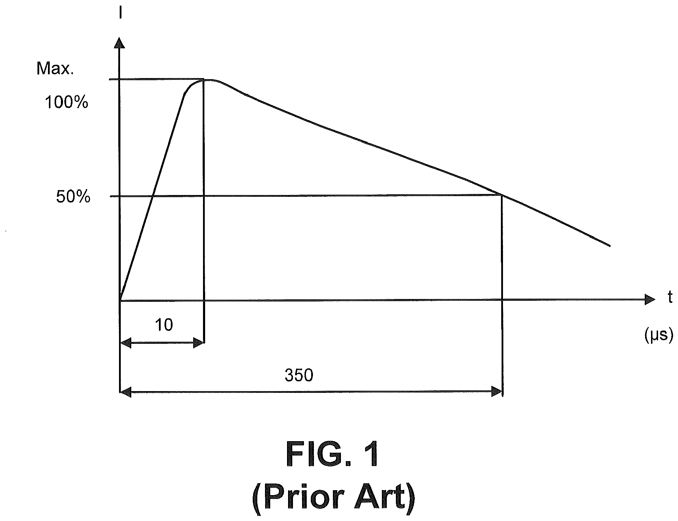

Some testing standards have determined specific current curves for simulating a surge event, such as, for example, a lightning strike. An example international testing standard includes IEC 61643-11 "Additional duty test for test Class I" for SPDs (Clause 8.3.4.4) based on the impulse discharge current waveform defined in Clause 8.1.1 of IEC 61643-11, typically referred to as 10/350 microsecond ("µs") current waveform ("10/350)µs current waveform"). For example, brief reference is made to FIG. 1, which is a plot illustrating the 10/350µs waveform. The 10/350µs current waveform may characterize a current wave in which the maximum current (100%) is reached at about 10 µs and the current is 50% of the maximum at about 350 µs. Under 10/350µs current waveform, the transferred charge, Q, and specific energy, W/R, to SPDs should be related with peak current according to one or more standards. For example, the IEC 61643-11 parameters to Class I SPD test are illustrated in Table 1, which follows:

**Table 1 Parameters for Class I SPD Test**

| *I*ᵢₘₚ within 50µs (kA) | Q within 5ms (As) | W/R within 5ms (kJ/Ω) |
|---|---|---|
| 25 | 12,5 | 156 |
| 20 | 10 | 100 |
| 12,5 | 6,25 | 39 |
| 10 | 5 | 25 |
| 5 | 2,5 | 6,25 |
| 2 | 1 | 1 |
| 1 | 0,5 | 0,25 |

However, the required Q and W/R can be achieved within a time interval several times lower than that corresponding to a zero impulse current flow.

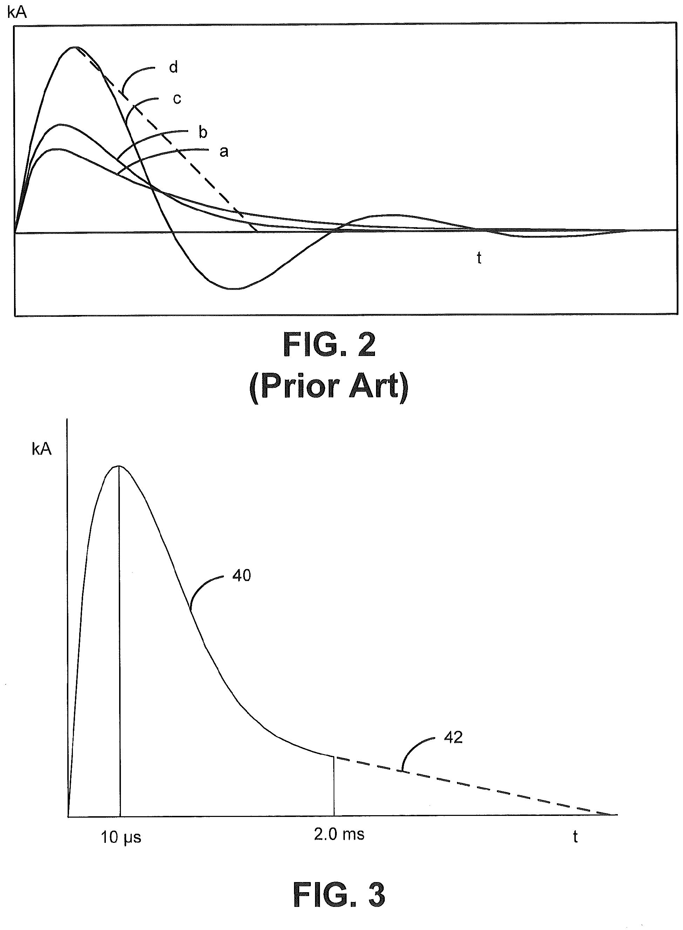

Conventionally, high current may be produced by the discharge of capacitors through an RL circuit. In order to obtain unidirectional current, critical and/or overcritical damping of the RLC circuit may be used and may be achieved by using a damping resistance R ≥ 2 (LC)^{0.5}. For example, brief reference is made to FIG. 2, which is a graph that illustrates current waveforms. A critically damped RLC circuit may be represented by curves "a" and "b" illustrated therein. Higher peak currents for the same generator energy can be achieved by an undercritical damping circuit (R<2(LC)^{0.5}). However, as illustrated by curve "c", the current waveform may be oscillatory. In order to get an unidirectional current a crowbar device may be used, usually in conjunction with a controllable three electrode gap, ignited at the instant of the crest value of the current so as to achieve a non-oscillating waveform, such as shown in curve "d". Such crowbar devices may be successful at producing current waveforms according to one or more testing standards. However, such devices may require calibration and synchronization for different types of varistor based SPDs. Because they may be configured to trigger at the peak current. As such a different generator may be used for each type of SPD.

Additionally, the application of greater Q and W/R than is specified in the test standard may result in excessive electrical and thermal stress on the SPD being tested. For example, the SPD being tested may experience excessive electrical and mechanical stress corresponding to the 'tail' of the 10/350µs waveform. Such stress may be particularly critical regarding the performance of varistors.

DE4341924 discloses a circuit in which an oscillator is connected to a pulse current generator and consists of serially connected elements, i.e. a high voltage rectifier diode (D), charging resistance (RI), damping resistance (Rd), circuit inductance (L), triggerable high voltage radio path (SF), test object, parallel high voltage part (Zh) and low voltage (Zn) part of a potential divider for measuring the voltage on the test object and a pulse current capacitor (C) connected in parallel with the test object. A metal oxide varistor (MOV) or other element connected into the serial oscillator circuit prevents the oscillator from swinging through at a current null transition. Several pulse current circuits can be used to produce a pulse current with a longer return half-crest-value time.

EP2336793 discloses an impulse current generator including first and second output terminals to which the load is connected, a capacitor, an inductance, a resistor, and a discharge gap device connected in series between the first and second output terminals, and a DC charge circuit configured to charge the capacitor. The discharge gap device comprises a fixed electrode, movable electrode, and an electrode drive configured to drive the movable electrode toward the fixed electrode and to bring the movable electrode into contact with the fixed electrode.

KR100992429 discloses an impulse current testing apparatus equipped with a crowbar switch module in which an impulse waveform generating unit is in parallel with a first spark gap and includes a first charging unit and a crowbar switch module. A wave-tail controlling unit is in electric connection between the first spark gap and a test load in order to control a wave-tail part in an impulse waveform. If the wave-head part of an impact current applied to the first spark gap, a controlling unit turns-off a first switch and turns-on a second switch in order to form the wave-tail part in the impulse waveform.

KR20120044689 discloses a lightning stroke current generator for implementing a certification test, a performance test, an inspection test, and a delivery test based on international standards by generating lightning stroke current waveforms which are adequate for the international standards. The lightning stroke current generator is composed of a short time lightning stroke current generating unit, a high voltage impulse generating unit, and a controller for the short time lightning stroke current generating unit. The short time lightning stroke current generating unit includes a first direct current high voltage generating unit and a lightning stroke current generating unit. The first direct current high voltage generating unit generates direct current output voltages. The lightning stroke current generating unit receives the direct current output voltages from the direct current high voltage generating unit and charges electric charges for generating impulse currents. The light stroke current generating part discharges the electric charges to generate the impulse currents to be transformed according to wave head parts and wave tail parts.

### SUMMARY

Devices according to embodiments of the present invention may include an impulse current generator that is configured to provide a direct impulse current (DIC) (discharge of capacitors through an RL circuit) that includes a specified waveform to a test load during a test duration, a continuous power supply that is configured to provide a continuous power to the test load during the test duration, a trigger circuit that is configured to determine a trigger condition based on the DIC and to generate a trigger signal responsive to determining the trigger condition, and a current bypass circuit that is configured to receive the trigger signal generated by the trigger circuit and to conduct a majority portion of the DIC being conducted by the load responsive to the trigger signal.

In some embodiments, the specified waveform has a peak current value at about 10 µs after initiation of the DIC and a current value of 50% of the peak current value at about 350 µs after initiation of the DIC.

Some embodiments provide that the current bypass circuit includes a thyristor that includes a gate that is coupled to the trigger circuit and that is configured to receive the trigger signal. Some embodiments provide that the trigger condition corresponds to a given time after the DIC is generated. In some embodiments, the given time is in a range of about 1.0 ms to about 3.0 ms. Some embodiments provide that the given time is in a range of about 1.8 ms to about 2.3 ms. In some embodiments, the given time is about 2.0 ms.

Some embodiments provide that the test load includes a surge protection device and that a maximum value of the DIC is greater than about 1000 amperes. In some embodiments, the surge protection device includes a metal oxide varistor.

Some embodiments provide that the trigger circuit is further configured to determine the trigger condition based on a voltage across the test load. In some embodiments, the trigger circuit may estimate the voltage developed across the test load that exceeds a threshold voltage, a time delay control configured to generate an elapsed time signal after the residual voltage has exceeded the threshold voltage for a given time delay, and a voltage pulse generator that is configured to generate a voltage pulse that is received by the current bypass circuit as the trigger signal.

Some embodiments include a blocking diode between the impulse current generator and the test load to block current generated by the continuous current supply from conducting through the impulse current generator. Some embodiments include a current rate limiter that is connected in series with the current bypass circuit and that is configured to limit the rate of change of current flowing through the current bypass circuit and a voltage rate limiter that is connected in parallel with the current bypass circuit and that is configured to limit the rate of a voltage rise across the current bypass circuit.

Some embodiments of the present invention are directed to methods for testing a surge protection device. Such methods may include applying a substantially continuous power to the surge protection device during a test duration, generating a direct impulse current (DIC) that corresponds to a specified waveform and applying the DIC to the surge protection device, generating a trigger signal responsive to a trigger condition that corresponds to a time duration of the DIC applied to the surge protection device, and conducting a majority portion of the DIC to bypass the surge protection device in response to generating the trigger signal.

In some embodiments, the specified waveform has a peak current value at about 10 µs after initiation of the DIC and a current value of 50% of the peak current value at about 350 µs after initiation of the DIC. Some embodiments provide that the time duration is in a range of about 1.0 ms to about 3.0 ms.

Some embodiments provide that the surge protection device includes a metal oxide varistor and a maximum value of the DIC is greater than about 1000 amperes. Some embodiments provide that the time duration of the DIC applied to the surge protection device is initiated by a voltage across the surge protection device exceeding a voltage threshold.

Some embodiments include blocking current generated by a continuous current supply from conducting through an impulse current generator. Yet further embodiments include limiting a rate of change of current flowing through a current bypass circuit and limiting a rate of a voltage rise across the current bypass circuit.

Some embodiments of the present invention are directed to devices that include a crowbar circuit connected in parallel with a test load. The crowbar circuit may be configured to conduct a DIC at a given time after the DIC is applied to the test load. Some embodiments provide that the crowbar circuit includes a thyristor that includes a gate and that is configured to conduct the DIC at the given time responsive to a trigger signal being applied to the gate, a trigger circuit that is configured to sense a voltage across the thyristor and to generate the trigger signal to be received at the gate of the thyristor, a first blocking diode that is connected between the thyristor and the test load and that is configured to block alternating current (AC) voltage from conducting through the crowbar circuit, and a second blocking diode that is connected in series with the thyristor and that is configured to block a recharging current to impulse current generator capacitors during a discharge of the impulse current.

In some embodiments, the crowbar circuit includes a current rate limiter that is connected in series with the thyristor and that is configured to limit the rate of change of current flowing through the thyristor and a voltage rate limiter that is connected in parallel with the thyristor and that is configured to limit the rate of a voltage rise across the thyristor. In some embodiments, the test load includes a metal oxide varistor and a maximum value of the DIC is greater than about 1000 amperes.

Some embodiments provide that the trigger circuit is configured to estimate a voltage that develops across the thyristor and that exceeds a threshold voltage. The trigger circuit may include a time delay control configured to generate an elapsed time signal after the residual voltage has exceeded the threshold voltage for a given time delay and a voltage pulse generator that is configured to generate a voltage pulse that is received by the thyristor as the trigger signal.

Further features, advantages and details of the present invention will be appreciated by those of ordinary skill in the art from a reading of the figures and the detailed description of the preferred embodiments that follow, such description being merely illustrative of the present invention.

It is noted that aspects of the invention described with respect to one embodiment, may be incorporated in a different embodiment although not specifically described relative thereto. That is, all embodiments and/or features of any embodiment can be combined in any way and/or combination, within the scope of the invention as defined by the appended claims. These and other objects and/or aspects of the present invention are explained in detail in the specification set forth below.

### BRIEF DESCRIPTION OF THE DRAWINGS

The accompanying figures are included to provide a further understanding of the present invention, and are incorporated in and constitute a part of this specification. The drawings illustrate some embodiments of the present invention and, together with the description, serve to explain principles of the present invention.
FIG. 1 is a plot illustrating a conventional 10/350µs current waveform used for approximating surges.
FIG. 2 is a plot illustrating 10/350µs current waveforms produced by critical, overcritical, undercritical and a generator with a crowbar circuit.
FIG. 3 is a plot of a 10/350µs current waveform and a current waveform generated by a crowbar device that is triggered according to some embodiments of the present invention.
FIG. 4 is a block diagram illustrating a conventional system for testing surge protection devices.
FIG. 5 is a block diagram illustrating a system for testing surge protection devices according to some embodiments of the present invention.
FIG. 6 is a block diagram illustrating a system for testing surge protection devices according to some embodiments of the present invention.
FIG. 7 is a block diagram illustrating a trigger circuit according to some embodiments of the present invention.
FIG. 8 is a schematic diagram representing a circuit of a crowbar circuit in a system for testing surge protection as illustrated in FIGS. 5 and 6.
FIG. 9 is a schematic diagram representing a trigger circuit in a crowbar circuit as illustrated in FIGS. 5-8.
FIG. 10 is a block diagram illustrating operations corresponding to systems, methods and apparatus for testing surge protection devices according to some embodiments of the present invention.

### DETAILED DESCRIPTION

The present invention now will be described more fully hereinafter with reference to the accompanying drawings, in which illustrative embodiments of the invention are shown. In the drawings, the relative sizes of regions or features may be exaggerated for clarity. This invention may, however, be embodied in many different forms and should not be construed as limited to the embodiments set forth herein; rather, these embodiments are provided so that this disclosure will be thorough and complete, and will fully convey the scope of the invention to those skilled in the art.

It will be understood that when an element is referred to as being "coupled" or "connected" to another element, it can be directly coupled or connected to the other element or intervening elements may also be present. In contrast, when an element is referred to as being "directly coupled" or "directly connected" to another element, there are no intervening elements present. Like numbers refer to like elements throughout.

In addition, spatially relative terms, such as "under", "below", "lower", "over", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "under" or "beneath" other elements or features would then be oriented "over" the other elements or features. Thus, the exemplary term "under" can encompass both an orientation of over and under. The device may be otherwise oriented (rotated 90 degrees or at other orientations) and the spatially relative descriptors used herein interpreted accordingly.

Well-known functions or constructions may not be described in detail for brevity and/or clarity.

As used herein the expression "and/or" includes any and all combinations of one or more of the associated listed items.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As disclosed herein, a novel crowbar circuit is introduced which may bypass the generated impulse current from a test device, such as a surge protection device (SPD), after the Q and W/R defined under one or more test standards is applied. In this manner, excessive electrical and thermal stress on SPDs may be avoided. Some embodiments provide that this may be important in that the latter stress may be critical for the performance of varistors. Additionally, embodiments described herein may avoid the requisite calibration corresponding to conventional crowbar devices.

Simulation and experimental results for high current generators have shown that the limiting values of charge and the specific energy transferred to Class I SPDs under 10/350µs according to IEC 61643-11 standard can be achieved within about 2.0 ms. Thus, some embodiments of a crowbar circuit according to the present invention have been developed and incorporated into high current generators. The crowbar circuits may short the capacitor bank about 2.0 ms after the application of the impulse current waveform. In that manner, the SPD may be tested according to IEC standard in terms of peak value, charge transfer and specific energy without excessive electrical and thermal stress on the SPD.

As disclosed herein, some embodiments of a crowbar device herein may activate at a given time after the current begins flowing through the SPD. In some embodiments, the time may be pre-specified and the time period may begin based on one or more circuit conditions. After the elapsed time, the impulse current may bypass the SPD by flowing through a thyristor or other switchable conducting device. In this manner, the impulse current may flow through SPD until the defined Q and W/R are provided and then the remaining part of the impulse current may flow through crowbar device. For example, brief reference is now made to FIG. 3, which is a plot of a 10/350µs current waveform and a current waveform generated by a crowbar device that is triggered according to some embodiments of the present invention. As illustrated, the SPD impulse current 40 (solid line) flows through the SPD until the crowbar circuit activates. The bypassed impulse current 42 (dashed line) flows through the crowbar circuit once the crowbar circuit is activated. The plot also illustrates the time at which the crowbar circuit according to some embodiments of the present invention may trigger, namely, about 2.0 milliseconds (ms). In contrast, circuits of the prior art may typically trigger around the peak current, such as around 10 microseconds (µsec), which may require significant calibration to be used on different devices and/or device types.

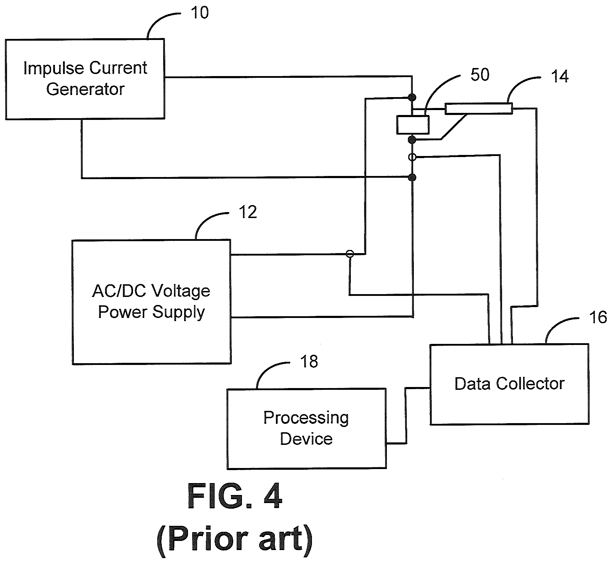

Brief reference is made to FIG. 4, which is a block diagram illustrating a conventional system for testing surge protection devices. The system includes an impulse current generator 10 that is configured to deliver an impulse current to a test load 50. An continuous power supply 12 is configured to provide a substantially continuous voltage across the test load 50 during the testing process. Some embodiments provide that the continuous power supply 12 may be AC, DC and/or AC/DC. A probe 14, such as a high voltage probe, may be connected across the test load and may generate probe signals corresponding to the voltage across the test load 50. A data collector 16 may receive the probe signals from the probe 14 and collect, format, and/or store the collected data, which may be further received and analyzed using a processing device 18. Some embodiments provide that the data collector may be, for example, an oscilloscope. The processing device 18 may include any of a number of different processing devices such as mobile and/or stationary computers, among others.

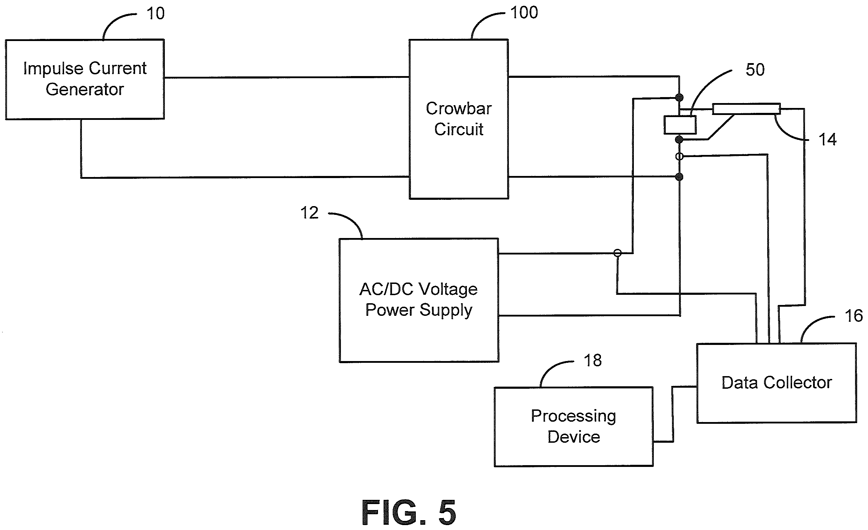

Reference is now made to FIG. 5, which is a block diagram illustrating a system for testing surge protection devices according to some embodiments of the present invention. In addition to the elements described above regarding FIG. 4, the repeated description of which will be omitted herein, the system according to some embodiments includes a crowbar circuit 100 connected between the impulse current generator 10 and the test load 50.

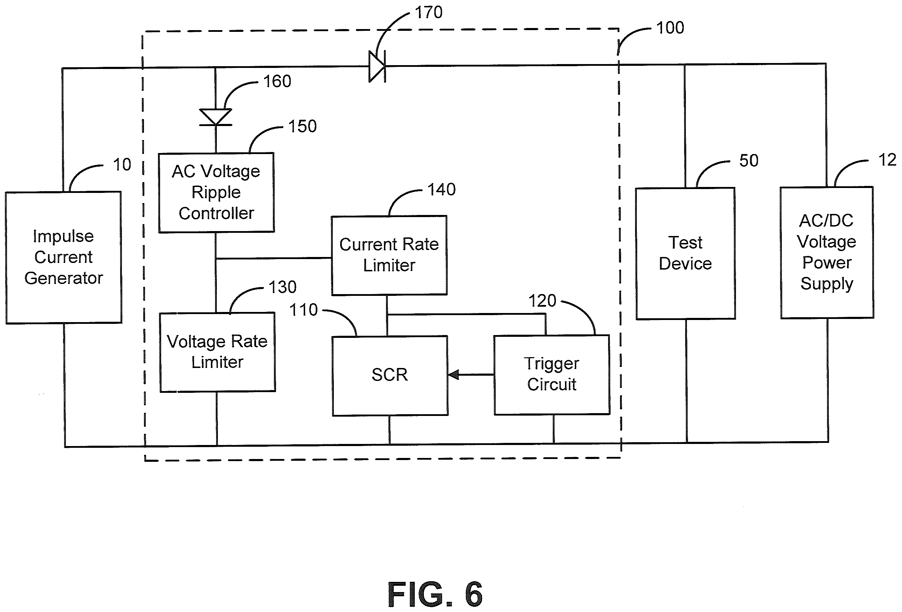

Reference is now made to FIG. 6, which is a block diagram illustrating a system for testing surge protection devices according to some embodiments of the present invention. Although described as a system in some embodiments, one or more of the components disclosed herein may be combined in to a single device that provides multiple functionality. In some embodiments, the system may include an impulse current generator 10 that is configured to provide a direct impulse current (DIC) that includes a specified waveform to a test device 50 during a test duration. Some embodiments provide that the test device 50 may include a SPD, including but not limited to a metal oxide varistor, among others. As used herein, the test device 50 may also be referred to as a test load such that the terms may be used interchangeably herein. Some embodiments provide that a maximum value of the DIC is greater than about 1000 amperes (1kA). For example, a maximum current may be about 2kA, 5kA, 10kA, 12.5kA, 20kA and/or 25kA, among others. The specified waveform current may be is a 10/350 microsecond current waveform, however, the invention is not so limited. For example, embodiments disclosed herein may be used in conjunction with a 8/20 microsecond current waveform (as defined in Clause 8.1.2 of IEC 61643-11), among others.

A continuous power supply 12 may be configured to provide a substantially continuous power to the test device 50 during the test duration. Some embodiments provide that the continuous power supply 12 is an AC voltage power supply. Some embodiments provide that the continuous power supply 12 may be AC, DC and/or AC/DC. As described below, the AC power voltage is not shorted via the crowbar device 100 and may be continuously applied to the test device 50 during testing.

Portions of the system may be characterized as the crowbar device 100 as described above. For example, a trigger circuit 120 may be configured to determine a trigger condition that corresponds to the DIC and to generate a trigger signal in response to determining the trigger condition. In some embodiments, the trigger condition corresponds to a given time after the DIC is generated while some embodiments provide that the trigger condition is a given time after a specified voltage is detected across the test device 50 or another circuit element. In some embodiments, the given time is in a range of about 1.0 ms to about 3.0 ms, whereas some embodiments provide that the given time is in a range of about 1.8 ms to about 2.3 ms. In some embodiments, the given time is about 2.0 ms.

Some embodiments provide that the trigger circuit 120 is configured to determine the trigger condition based on a voltage across the test device 50 whereas in some other embodiments the trigger circuit 120 determines the trigger condition based on a voltage across a current bypass device, such as a Silicon Controlled Rectifier (SCR) 110.

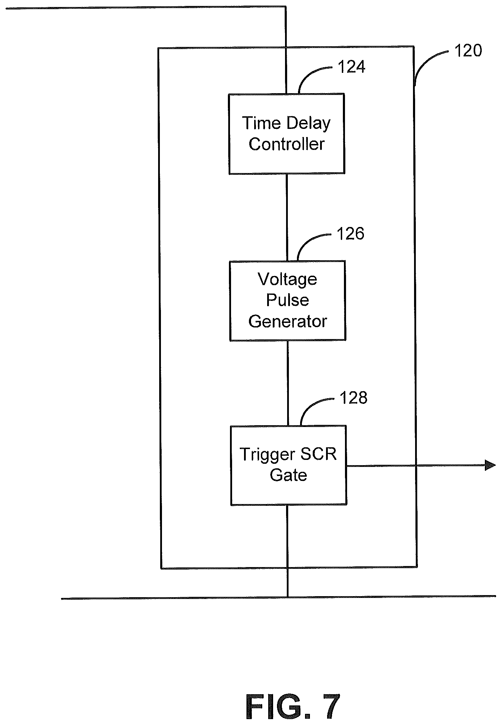

Brief reference is made to FIG. 7, which is a block diagram illustrating a trigger circuit according to some embodiments of the present invention. In some embodiments, the trigger circuit 120 is configured to determine that a residual voltage across the test load exceeds a threshold voltage. Although not illustrated, the trigger circuit 120 may include a voltage sensor configured to estimate a residual voltage across the thyristor that exceeds a threshold voltage. Some embodiments provide that the threshold voltage is given while other embodiments provide that a user may input a threshold voltage value. A time delay controller 124 is configured to generate an elapsed time signal after the application of the impulse current. The time of application of the impulse current may be detected when the residual voltage exceeds the threshold voltage. In some embodiments, the impulse current may be detected using a current sensor. The elapsed time may be based on a given time delay that is fixed and/or may include a time delay that, may be adjusted and/or provided by a user and/or other data source. A voltage pulse generator 126 may generate a voltage pulse once the time delay is elapsed. The voltage pulse may be used to trigger 128 the SCR 110.

Referring again to FIG. 6, a current bypass circuit, such as a silicon controlled rectifier (SCR) 110 may be configured to receive the trigger signal generated by the trigger circuit 120 and to conduct a majority portion of the DIC being conducted by the test device 50 responsive to receiving the trigger signal. Some embodiments provide that SCR 110 is a thyristor that includes a gate that is coupled to the trigger circuit 120 and that is configured to receive the trigger signal.

Some embodiments further include a blocking diode 170 connected between the impulse current generator 10 and the test device 50 to block current generated by the continuous power supply 12 from conducting through the impulse current generator 10 or the crowbar circuit 100. Some embodiments provide that the continuous current supply 12 may be AC, DC and/or AC/DC. In some embodiments, a blocking diode 160 may block the flow of AC current from the continuous power supply 12 to the crowbar circuit 100. The blocking diodes 160 and 170 may be selected to function while conducting impulse and/or surge currents having peak values of several thousand Amperes. A current rate limiter 140 may be connected in series with the SCR 110 and that may limit the rate of change of current flowing through the SCR 110. The current rate limiter may include an inductor that is operable to slow the rate of change in current through the SCR 110 to protect the SCR 110.

Some embodiments provide that a voltage rate limiter 130 may be connected in parallel with the SCR 110 and may limit the rate of a voltage rise across the SCR 110. In some embodiments, the voltage rate limiter 130 may include a resistive-capacitive (RC) circuit that is operable to slow the rise in voltage across the SCR 110 to protect the SCR 110 from failing by short circuiting without a trigger signal applied to the gate.

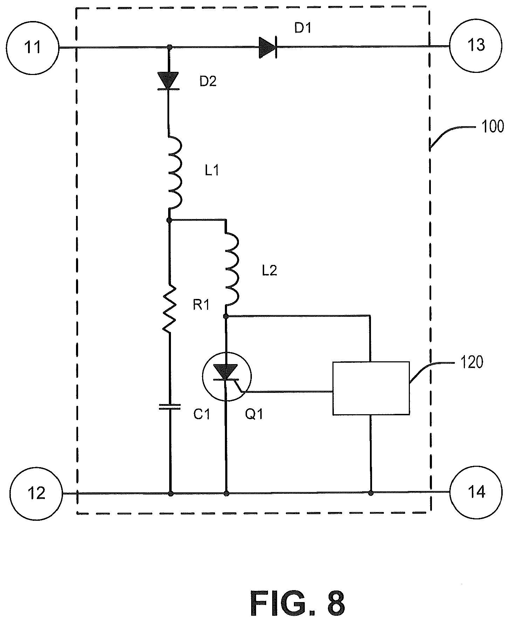

Reference is now made to FIG. 8, which is a schematic diagram representing a circuit of a crowbar circuit in a system for testing surge protection as illustrated in FIGS. 5 and 6. As discussed above, the crowbar circuit 100 may be incorporated into a current generator and may short a capacitor bank therein at a given time interval after the application of the impulse current waveform. For example, some embodiments provide that the given time interval is 2.0 ms after the application of the impulse current waveform, however, such embodiments are non-limiting. For example, the given time period may be longer or shorter than 2.0 ms. In this manner, the test device 50 may be tested according to one or more standards (e.g., IEC standards) in terms of peak value, charge transfer and/or specific energy, while avoiding excessive electrical and thermal stress on the test device 50.

Upon application of the impulse current, before the given time interval elapses, the impulse current flows through the test device 50. After the given time interval elapses, which may correspond to the satisfaction of the defined Q and W/R, the remaining impulse current may flow through the crowbar device 100.

In use and operation, the crowbar circuit 100 may include a thyristor SCR (Q1), which may be triggered to an on-state (conducting) at a specified time. For example, still referring to FIG. 8, the crowbar circuit 100 includes input terminals 11 and 12 to which an impulse current generator is connected. The crowbar circuit 100 may include terminals 13 and 14, which are load terminals that may be connected to an AC power supply 12 and the test device 50.

Some embodiments provide that the thyristor SCR Q1 may have a performance characteristic that defines a maximum rate of change of voltage (dv/dt) applied to the thyristor SCR Q1. In such embodiments, the thyristor SCR Q1 may self-trigger into a conduction mode if the dv/dt rating is exceeded. As such, some embodiments provide that a voltage rate change limiter, which may include a snubber circuit connected in parallel with the thyristor SCR Q1 and an inductance (L1) in series with the parallel combination of the SCR and the snubber circuit. In some embodiments, the snubber circuit may include a resistor R1 in series with a capacitor C1. Some embodiments provide that the resistor R1 may function to limit the discharge current via the capacitor C1 during the short circuit of the thyristor SCR Q1 to an acceptable level so as to prevent failure of the equipment. Some non-limiting embodiments provide that L1 may have an inductance value of about 9µH, however, some embodiments may provide that the inductance is more or less than 9µH.

In some embodiments, the time derivative of current (di/dt) through the thyristor SCR Q1 may be limited to a value of rated maximum by an inductive element L2. Inductor L2 may be installed in series with the Q1. Some non-limiting embodiments provide that L2 may have an inductance value of about 320 µH, however, the inductance may be more or less than about 320 µH. Some embodiments provide that diodes D1 and D2 block the flow of AC current from the power source to the crowbar device. In some embodiments, diodes D1 and D2 may be selected so as to withstand impulse and surge currents of peak values of several kA.

An inductor L1 may be used to control a voltage ripple corresponding to the AC voltage that is applied to the test device 50.

In some embodiments, a thyristor SCR Q1 may include a phase control thyristor that may provide high repetitive peak forward off-state and reverse voltages. For example, in some embodiments, the maximum peak forward off-state voltage that can be applied to the thyristor is around 5 kV. However, such embodiments are non-limiting as the thyristor may be able to withstand a substantially greater peak forward off-state voltage, such as, for example, 6kV or more. In this manner, the thyristor may withstand at least 6 kV peak forward off-state voltage in order not to turn-on at the wrong instant or get damaged. According to some embodiments, the thyristor may demonstrate high performance at surge currents.

A trigger circuit 120 may sense the voltage developed across the terminals of the test device 50 and, after a certain period of time, may generate a voltage impulse to the gate of the thyristor SCR Q1. Responsive to the voltage impulse at the gate, the thyristor SCR Q1 switches to an on-state (conducting) to bypass the impulse current from the test device 50.

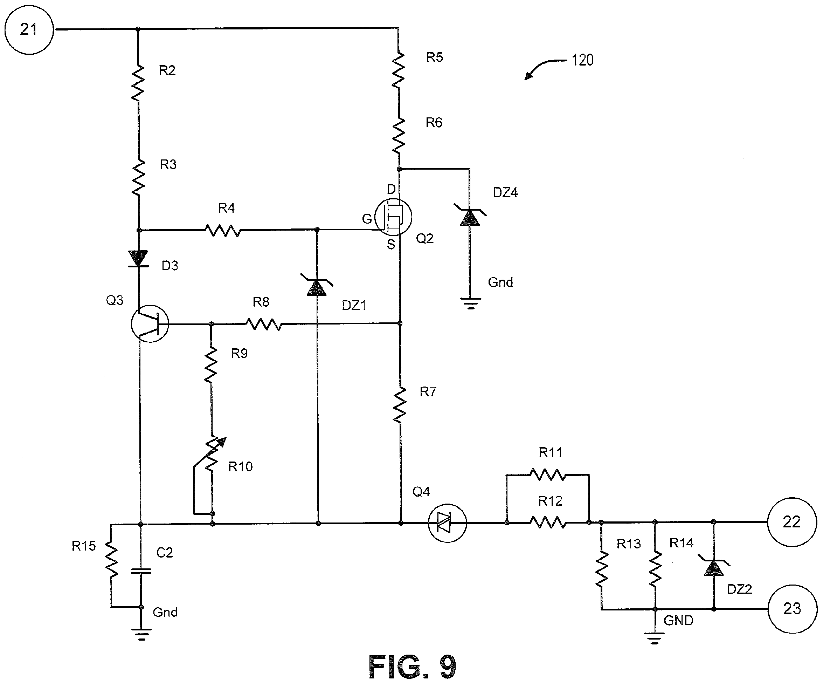

Reference is now made to FIG. 9, which is a schematic diagram representing a trigger circuit in a crowbar circuit as illustrated in FIGS. 5-8. During impulse current flow, the trigger circuit 120 senses the residual voltage of the test device 50. In some embodiments, under a DC supply voltage, capacitor C2 may be charged through D1 (FIG. 8) reverse current, which may affect trigger time. The effect may be reduced and/or mitigated by R15, which is connected in parallel with C2. Some embodiments provide that when the voltage across the capacitor C2 exceeds the breakdown voltage of a diode for alternating current (DIAC) Q4, the DIAC Q4 switches to an on-state and a pulse is produced at terminals 22 and 23. By adjusting the charging time of capacitor C2 to the breakdown voltage of the DIAC Q4 to the pre-specified time, Q1 triggering may be controlled.

Control of the time delay may depend on the value of the current flowing to capacitor C2. Some embodiments provide that the circuit charging the capacitor C2 may be a two level current regulator.

Still referring to FIG. 9, some embodiments provide that a MOSFET Q2 is biased into conduction by a positive gate voltage from the resistor R4. Current may flow through resistors R5, R6, MOSFET (Q1) and resistor R7, charging the capacitor C2. A voltage drop may be developed across R7 and consequently a voltage between base and emitter of transistor Q3 may be developed. By properly selecting resistors R8, R9 and R10 the transistor may be biased into conduction and the current may flow though diode D3 and transistor Q3. Resistor R2 may be selected according to an input voltage applied at terminal 21 in order for the MOSFET Q2 to be effectively biased. Resistor R5 may be selected in order to limit the current flowing though the drain of the MOSFET Q2 to avoid excessive and potentially damaging current levels. Zener diodes DZ1, DZ2 may be used to prevent failure at the gate of Q2 and Q1, respectively, against excessive voltage. Zener diode DZ4 may prevent failure at the drain of Q2. The time for charging C2, i.e. current flow to C2, may be adjusted by selecting values R8, R9 and R10. In some embodiments, to prevent initial charging of C2, resistor R15 may be connected in parallel to the capacitor C2.

The voltage pulse may be generated to the gate of the thyristor SCR Q1 when capacitor C2 is charged up to exceed the DIAC Q4 breakdown voltage. After the breakdown of the DIAC Q4 current is flowing through resistors R11 and R12 a voltage pulse is produced at terminals 22 and 23, thus thyristor SCR Q1 is triggered to an on state.

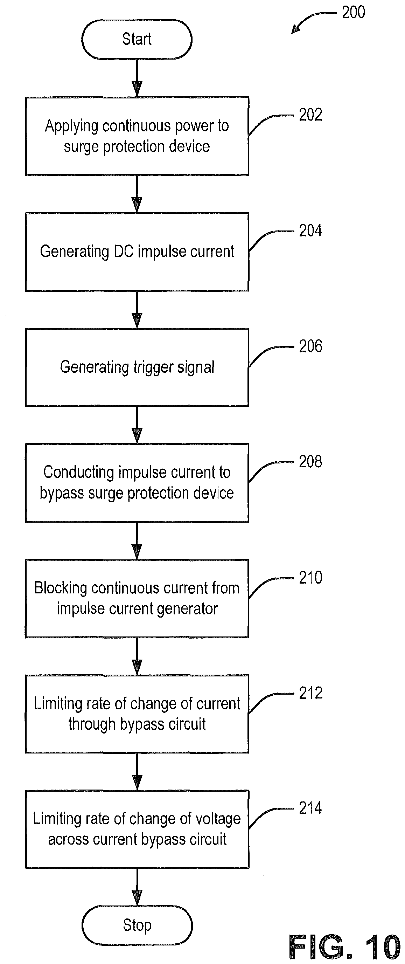

Reference is now made to FIG. 10, which is a block diagram illustrating operations corresponding to systems, methods and apparatus for testing surge protection devices according to some embodiments of the present invention. According to some embodiments, methods 200 for testing a surge protection device may include applying a substantially continuous power to the surge protection device during a test duration (block 202) and generating a direct impulse current (DIC) that corresponds to a specified waveform and applying the DIC to the surge protection device (block 204). In some embodiments, the specified waveform is a 10/350 microsecond current waveform. Some embodiments provide that the surge protection device is a metal oxide varistor and that a maximum value of the DIC is greater than about 1000 amperes.

Some embodiments include generating a trigger signal responsive to a trigger condition that corresponds to a time duration of the DIC applied to the surge protection device (block 206). In some embodiments, the time duration is in a range of about 1.0 ms to about 3.0 ms. Some embodiments provide that the time duration of the DIC applied to the surge protection device is initiated by a voltage across the surge protection device exceeding a voltage threshold.

Some embodiments include conducting a majority portion of the DIC to bypass the surge protection device in response to generating the trigger signal (block 208). For example, once the surge protection device has been exposed to the defined Q and W/R, the remaining portion of the DIC may be bypassed through another current path as provided herein. Some embodiments further include blocking current generated by a continuous current supply from conducting through a impulse current generator (block 210). In this manner, an early or unintentional triggering of the bypass current path may be avoided.

Additionally, some embodiments include limiting a rate of change of current flowing through a current bypass circuit (block 212). In some embodiments, devices in the current bypass circuit may have operational limitations regarding the rate of change of current flowing therethrough. Limiting the rate of change of the current flowing through such devices may prevent exceeding such operational limitations.

In some embodiments, operations may include limiting a rate of a voltage rise across the current bypass circuit (block 214). In some embodiments, devices in the current bypass circuit may have operational limitations regarding the rate of change of voltage applied thereto. Limiting the rate of change of the voltage applied to such devices may prevent exceeding such operational limitations.

Many alterations and modifications may be made by those having ordinary skill in the art, given the benefit of present disclosure, without departing from the scope of the invention. Therefore, it must be understood that the illustrated embodiments have been set forth only for the purposes of example, and that it should not be taken as limiting the invention as defined by the following claims.

## Claims

1. A testing device comprising:
an impulse current generator (10) that is configured to provide a direct impulse current DIC that includes a specified waveform to a test load (50) during a test duration;
a continuous power supply (12) that is configured to provide a continuous power to the test load during the test duration, **characterised in that** the testing device further comprises:
a trigger circuit (120) that is configured to determine a trigger condition that corresponds to a time duration of the DIC applied to the test load and to generate a trigger signal responsive to determining the trigger condition; and
a current bypass circuit (110) that is configured to receive the trigger signal generated by the trigger circuit and to conduct a majority portion of the DIC being conducted by the test load (50) responsive to the trigger signal.

2. The testing device according to Claim 1, wherein the specified waveform has a peak current value at about 10 µs after initiation of the DIC and a current value of 50% of the peak current value at about 350 µs after initiation of the DIC.

3. The testing device according to Claim 1, wherein the current bypass circuit comprises a thyristor that includes a gate that is coupled to the trigger circuit and that is configured to receive the trigger signal.

4. The testing device according to Claim 1, wherein the trigger condition corresponds to a given time after the DIC is generated.

5. The testing device according to Claim 4, wherein the given time is in a range of about 1.0 ms to about 3.0 ms.

6. The testing device according to Claim 4, wherein the given time is in a range of about 1.8 ms to about 2.3 ms.

7. The testing device according to Claim 4, wherein the given time is about 2.0 ms.

8. The testing device according to Claim 1, wherein the test load comprises a surge protection device, and wherein a maximum value of the DIC is greater than about 1000 amperes.

9. The testing device according to Claim 8, wherein the surge protection device comprises a metal oxide varistor.

10. The testing device according to Claim 1, wherein the trigger circuit is further configured to determine the trigger condition based on a voltage across the test load.

11. The testing device according to Claim 1, wherein the trigger circuit comprises:
a voltage sensor that is configured to estimate a residual voltage across the test load that exceeds a threshold voltage;
a time delay controller configured to generate an elapsed time signal after the residual voltage has exceeded the threshold voltage for a given time delay; and
a voltage pulse generator that is configured to generate a voltage pulse that is received by the current bypass circuit as the trigger signal.

12. The testing device according to Claim 1, further comprising a blocking diode between the impulse current generator and the test load to block current generated by the continuous current supply from conducting through the impulse current generator.

13. The testing device according to Claim 1, further comprising:
a current rate limiter that is connected in series with the current bypass circuit and that is that is configured to limit the rate of change of current flowing through the current bypass circuit; and
a voltage rate limiter that is connected in parallel with the current bypass circuit and that is configured to limit the rate of a voltage rise across the current bypass circuit.

14. A method for testing a surge protection device, the method comprising:
applying (202) a substantially continuous power to the surge protection device during a test duration;
generating (204) a direct impulse current DIC that corresponds to a specified waveform and applying the DIC to the surge protection device, **characterized in that** the method further comprises:
generating (206) a trigger signal responsive to a trigger condition that corresponds to a time duration of the DIC applied to the surge protection device; and
conducting (208) a majority portion of the DIC to bypass the surge protection device in response to generating the trigger signal.

15. The method according to Claim 14,
wherein the specified waveform has a peak current value at about 10 µs after initiation of the DIC and a current value of 50% of the peak current value at about 350 µs after initiation of the DIC,
wherein the time duration is in a range of about 1.0 ms to about 3.0 ms,
wherein the surge protection device comprises a metal oxide varistor,
wherein a maximum value of the DIC is greater than about 1000 amperes, and
wherein the time duration of the DIC applied to the surge protection device is initiated by a voltage across the surge protection device exceeding a voltage threshold.

## Patentansprüche

1. Testvorrichtung, umfassend:
einen Impulsstromgenerator (10), der ausgestaltet ist, um einer Testlast (50) während einer Testdauer einen Direktimpulsstrom DIC bereitzustellen, der eine spezifizierte Wellenform einschließt;
eine kontinuierliche Leistungsversorgung (12), die ausgestaltet ist, um der Testlast während der Testdauer eine kontinuierliche Leistung bereitzustellen,
**dadurch gekennzeichnet, dass** die Testvorrichtung des Weiteren umfasst:
eine Triggerschaltung (120), die ausgestaltet ist, um eine Triggerbedingung zu bestimmen, die einer Zeitdauer entspricht, in der der DIC an die Testlast angelegt worden ist, und um in Reaktion auf die Bestimmung der Triggerbedingung ein Triggersignal zu generieren; und
eine Stromumgehungsschaltung (110), die ausgestaltet ist, um das durch die Triggerschaltung generierte Triggersignal zu empfangen und in Reaktion auf das Triggersignal einen überwiegenden Anteil des DICs zu leiten, der durch die Testlast (50) geleitet wurde.

2. Testvorrichtung nach Anspruch 1, wobei die spezifizierte Wellenform einen Spitzenstromwert bei etwa 10 µs nach Initiierung des DICs und einen Stromwert von 50 % des Spitzenstromwerts bei etwa 350 µs nach Initiierung des DICs aufweist.

3. Testvorrichtung nach Anspruch 1, wobei die Stromumgehungsschaltung einen Thyristor umfasst, der ein Gate einschließt, das an die Triggerschaltung gekoppelt ist, und das ausgestaltet ist, um das Triggersignal zu empfangen.

4. Testvorrichtung nach Anspruch 1, wobei die Triggerbedingung einer gegebenen Zeit entspricht, nachdem der DIC generiert worden ist.

5. Testvorrichtung nach Anspruch 4, wobei die gegebene Zeit in einem Bereich von etwa 1,0 ms bis etwa 3,0 ms liegt.

6. Testvorrichtung nach Anspruch 4, wobei die gegebene Zeit in einem Bereich von etwa 1,8 ms bis etwa 2,3 ms liegt.

7. Testvorrichtung nach Anspruch 4, wobei die gegebene Zeit etwa 2,0 ms ist.

8. Testvorrichtung nach Anspruch 1, wobei die Testlast eine Überspannungsschutzvorrichtung umfasst, und wobei ein Maximalwert des DICs größer als etwa 1000 Ampere ist.

9. Testvorrichtung nach Anspruch 8, wobei die Überspannungsschutzvorrichtung einen Metalloxidvaristor umfasst.

10. Testvorrichtung nach Anspruch 1, wobei die Triggerschaltung des Weiteren ausgestaltet ist, um die Triggerbedingung basierend auf einer Spannung über der Testlast zu bestimmen.

11. Testvorrichtung nach Anspruch 1, wobei die Triggerschaltung umfasst:
einen Spannungssensor, der ausgestaltet ist, um eine Restspannung über der Testlast zu schätzen, die eine Schwellenspannung überschreitet;
eine Zeitverzögerungssteuerung, die ausgestaltet ist, um ein "Zeit verstrichen"-Signal zu generieren, nachdem die Restspannung die Schwellenspannung für eine gegebene Zeitverzögerung überschritten hat; und
einen Spannungsimpulsgenerator, der ausgestaltet ist, um einen Spannungsimpuls zu generieren, der von der Stromumgehungsschaltung als Triggersignal empfangen wird.

12. Testvorrichtung nach Anspruch 1, des Weiteren umfassend eine Sperrdiode zwischen dem Impulsstromgenerator und der Testlast, um zu verhindern, dass Strom, der durch die kontinuierliche Leistungsversorgung generiert wurde, durch den Impulsstromgenerator geleitet wird.

13. Testvorrichtung nach Anspruch 1, des Weiteren umfassend:
einen Stromratenbegrenzer, der in Reihe mit der Stromumgehungsschaltung geschaltet ist und der ausgestaltet ist, um die Änderungsrate des Stroms zu begrenzen, der durch die Stromumgehungsschaltung fließt; und
einen Spannungsratenbegrenzer, der parallel zu der Stromumgehungsschaltung geschaltet ist und der ausgestaltet ist, um die Rate eines Spannungsanstiegs über der Stromumgehungsschaltung zu begrenzen.

14. Verfahren zum Testen einer Überspannungsschutzvorrichtung, wobei das Verfahren umfasst:
Anlegen (202) einer im Wesentlichen kontinuierlichen Leistung an die Überspannungsschutzvorrichtung während einer Testdauer;
Generieren (204) eines Direktimpulsstroms DIC, der einer spezifizierten Wellenform entspricht, und Anlegen des DICs an die Überspannungsschutzvorrichtung, **dadurch gekennzeichnet, dass** das Verfahren des Weiteren umfasst:
Generieren (206) eines Triggersignals in Reaktion auf eine Triggerbedingung, die einer Zeitdauer des DICs entspricht, der an die Überspannungsschutzvorrichtung angelegt wird; und
Leiten (208) eines überwiegenden Anteils des DICs zur Umgehung der Überspannungsschutzvorrichtung in Reaktion auf das Generieren des Triggersignals.

15. Verfahren nach Anspruch 14,
wobei die spezifizierte Wellenform einen Spitzenstromwert bei etwa 10 µs nach Initiierung des DICs und einen Stromwert von 50 % des Spitzenstromwerts bei etwa 350 µs nach Initiierung des DIC aufweist, wobei die Zeitdauer in einem Bereich von etwa 1,0 ms bis etwa 3,0 ms liegt,
wobei die Überspannungsschutzvorrichtung einen Metalloxidvaristor umfasst,
wobei ein Maximalwert des DICs größer als etwa 1000 Ampere ist, und
wobei die Zeitdauer des DICs, der an die Überspannungsvorrichtung angelegt wird, dadurch initiiert wird, dass eine Spannung über der Überspannungsschutzvorrichtung eine Schwellenspannung übersteigt.

## Revendications

1. Dispositif d'essai comprenant :
un générateur de courant de choc (10) qui est configuré pour délivrer un courant de choc continu DIC qui comporte une forme d'onde spécifiée à une charge d'essai (50) pendant une durée d'essai ;
une source de puissance continue (12) qui est configurée pour délivrer une puissance continue à la charge d'essai pendant la durée d'essai, **caractérisé en ce que** le dispositif d'essai comprend en outre :
un circuit de déclenchement (120) qui est configuré pour déterminer une condition de déclenchement qui correspond à une durée du DIC appliqué à la charge d'essai et pour générer un signal de déclenchement en réponse à la détermination de la condition de déclenchement ; et
un circuit de dérivation de courant (110) qui est configuré pour recevoir le signal de déclenchement généré par le circuit de déclenchement et pour conduire une majeure partie du DIC conduit par la charge d'essai (50) en réponse au signal de déclenchement.

2. Dispositif d'essai selon la revendication 1, dans lequel la forme d'onde spécifiée a une valeur de courant de crête environ 10 µs après l'initiation du DIC et une valeur de courant égale à 50 % de la valeur de courant de crête environ 350 µs après l'initiation du DIC.

3. Dispositif d'essai selon la revendication 1, dans lequel le circuit de dérivation de courant comprend un thyristor qui comporte une grille qui est couplée au circuit de déclenchement et qui est configurée pour recevoir le signal de déclenchement.

4. Dispositif d'essai selon la revendication 1, dans lequel la condition de déclenchement correspond à un temps donné après que le DIC a été généré.

5. Dispositif d'essai selon la revendication 4, dans lequel le temps donné se situe dans une gamme d'environ 1,0 ms à environ 3,0 ms.

6. Dispositif d'essai selon la revendication 4, dans lequel le temps donné se situe dans une gamme d'environ 1,8 ms à environ 2,3 ms.

7. Dispositif d'essai selon la revendication 4, dans lequel le temps donné est d'environ 2,0 ms.

8. Dispositif d'essai selon la revendication 1, dans lequel la charge d'essai comprend un dispositif de protection contre les surtensions, et dans lequel une valeur maximale du DIC est supérieure à environ 1000 ampères.

9. Dispositif d'essai selon la revendication 8, dans lequel le dispositif de protection contre les surtensions comprend une varistance à oxyde métallique.

10. Dispositif d'essai selon la revendication 1, dans lequel le circuit de déclenchement est également configuré pour déterminer la condition de déclenchement en se basant sur une tension aux bornes de la charge d'essai.

11. Dispositif d'essai selon la revendication 1, dans lequel le circuit de déclenchement comprend :
un capteur de tension qui est configuré pour estimer une tension résiduelle aux bornes de la charge d'essai qui dépasse une tension seuil ;
un contrôleur de temporisation configuré pour générer un signal de temps écoulé après que la tension résiduelle a dépassé la tension seuil pendant un délai donné ; et
un générateur d'impulsion de tension qui est configuré pour générer une impulsion de tension qui est reçue par le circuit de dérivation de courant comme le signal de déclenchement.

12. Dispositif d'essai selon la revendication 1, comprenant en outre une diode de blocage entre le générateur de courant de choc et la charge d'essai pour empêcher un courant généré par la source de courant continu de circuler à travers le générateur de courant de choc.

13. Dispositif d'essai selon la revendication 1, comprenant en outre :
un limiteur de taux de courant qui est branché en série avec le circuit de dérivation de courant et qui est configuré pour limiter le taux de variation de courant circulant à travers le circuit de dérivation de courant ; et
un limiteur de taux de tension qui est branché en parallèle avec le circuit de dérivation de courant et qui est configuré pour limiter le taux d'une augmentation de tension aux bornes du circuit de dérivation de courant.

14. Procédé destiné à tester un dispositif de protection contre les surtensions, le procédé comprenant :
l'application (202) d'une puissance sensiblement continue au dispositif de protection contre les surtensions pendant une durée d'essai ;
la génération (204) d'un courant de choc continu DIC qui correspond à une forme d'onde spécifiée et l'application du DIC au dispositif de protection contre les surtensions, **caractérisé en ce que** le procédé comprend en outre :
la génération (206) d'un signal de déclenchement en réponse à une condition de déclenchement qui correspond à une durée du DIC appliqué au dispositif de protection contre les surtensions ; et
la conduite (208) d'une majeure partie du DIC pour qu'elle contourne le dispositif de protection contre les surtensions en réponse à la génération du signal de déclenchement.

15. Procédé selon la revendication 14,
dans lequel la forme d'onde spécifiée a une valeur de courant de crête environ 10 µs après l'initiation du DIC et une valeur de courant égale à 50 % de la valeur de courant de crête environ 350 µs après l'initiation du DIC,
dans lequel la durée se situe dans une gamme d'environ 1,0 ms à environ 3,0 ms,
dans lequel le dispositif de protection contre les surtensions comprend une varistance à oxyde métallique,
dans lequel une valeur maximale du DIC est supérieure à environ 1000 ampères, et
dans lequel la durée du DIC appliqué au dispositif de protection contre les surtensions est initiée par une tension aux bornes du dispositif de protection contre les surtensions dépassant un seuil de tension.
